# EUROPÄISCHE PATENTSCHRIFT

(11) **EP 1 194 611 B1**
(45) Veröffentlichungstag und Bekanntmachung des Hinweises auf die Patenterteilung: **03.11.2004**
(21) Anmeldenummer: 00938445.4
(22) Anmeldetag: 04.07.2000
(51) Int. Cl.: C23C 16/513, C23C 16/44

(54) **ANLAGE UND VERFAHREN ZUR VAKUUMBEHANDLUNG BZW. ZUR PULVERHERSTELLUNG**
INSTALLATION AND METHOD FOR VACUUM TREATMENT OR THE PRODUCTION OF POWDER
INSTALLATION ET PROCEDE POUR LE TRAITEMENT SOUS VIDE OU LA PRODUCTION DE POUDRE

(30) Priorität: 13.07.1999 CH 129299
(43) Veröffentlichungstag der Anmeldung: 10.04.2002
(73) Patentinhaber: Unaxis Balzers Aktiengesellschaft, 9496 Balzers (LI)
(72) Erfinder: KARNER, Johann, A-6800 Feldkirch (AT); PEDRAZZINI, Mauro, FL-9492 Eschen (LI)
(74) Vertreter: Troesch, Jacques J., Dr. sc. nat.
(86) Internationale Anmeldenummer: PCT/CH2000/000364
(87) Internationale Veröffentlichungsnummer: WO 2001/004379

(56) Entgegenhaltungen:
- EP-A- 0 724 026
- DE-A- 4 310 286
- RAO N ET AL: "NANOPARTICLE FORMATION USING A PLASMA EXPANSION PROCESS" PLASMA CHEMISTRY AND PLASMA PROCESSING, Bd. 15, Nr. 4, 1. Dezember 1995 (1995-12-01), Seiten 581-606, XP000539562 ISSN: 0272-4324

## Beschreibung

Die vorliegende Erfindung betrifft eine Vakuumbehandlungsanlage nach dem Oberbegriff von Anspruch 1 bzw. ein Verfahren zur Herstellung nach demjenigen von Anspruch 9.

Die vorliegende Erfindung setzt sich grundsätzlich zum Ziel, reaktiv plasmaunterstützt, d.h. durch ein PECVD-Verfahren, Materialien auf eine Abscheidungsoberfläche abzuscheiden, seien dies Materialien, die ganz allgemein äusserst schwierig herzustellen sind, nämlich metastabile Materialien wie cBN, α-Al₂O₃, C₃N₄ oder, und insbesondere, Diamantmaterial, oder grundsätzlich Materialien, aber dies mit möglichst hoher Abscheidungsrate und bei möglichst tiefer Temperatur, insbesondere dann, wenn Si-haltige Verbindungen, ganz besonders mikrokristallines µC-Si:H abgeschieden werden soll.

Aus der DE 43 10 286 sind eine Vakuumsbehandlungsanlage, sowie ein Herstellungsverfahren eingangs genannter Art bekannt, mittels welchen grössere Substratflächen überzogen werden sollen. Hierzu werden parallele, nebeneinander liegende Plasmastrahlen mittels magnetischer Felder in ein sich parallel zu dem Substrat ausdehnendes Plasma mit flächiger, schichtähnlicher Gestalt transformiert. Mittels Düsen werden Gase, im wesentlichen senkrecht zum Flächenplasma und dem Substrat, letzterem zugedüst.

Aus der EP-0 724 026 derselben Anmelderin wie vorliegende Anmeldung, entsprechend der US 5 753 045, ist es bekannt, schwierig herzustellende Schichten grossflächig abzulegen, insbesondere aus metastabilen Materialien, insbesondere aus Diamant, cBN, α-Al₂O₃ oder C₃N₄. Bezüglich der Definition "metastabile Materialien" sei auf "Lehrbuch der anorganischen Chemie", Hohlemann-Wiberg, Walter Gruyer, Berlin, New York 1976, 81. - 90. Auflage, Seiten 183 ff., verwiesen. In Abkehr vom damals bereits vorbekannten Einsatz einer Mehrzahl einzelner Plasmastrahlen nebeneinander, wird dies dadurch realisiert, dass, bezüglich der Achse eines Plasmastrahls, Werkstückoberflächen so versetzt angeordnet werden, dass daran eine Plasmadichte von höchstens 20% der in der Plasmastrahlachse herrschenden Maximaldichte vorherrscht. Es wird eine Gasströmung parallel zur Achse des Plasmastrahls erstellt.

Gemäss der Schweizer Patentanmeldung 794/99 derselben Anmelderin entsprechend der WO 00/66806, wurde erkannt, dass sich das Verfahren gemäss EP-0 724 026 erstaunlicherweise auch zum Hochrate-Beschichten von Oberflächen einerseits, zur Erzeugung von pulver- bzw. clusterförmigem Material auf einer Auffangoberfläche anderseits eignet.

Ausgehend von einer Anlage bzw. einem Verfahren der in der DE 43 10 286 vorbekannten Art, ist es Aufgabe der vorliegenden Erfindung, eine Anlage bzw. ein Verfahren zu schaffen mittels welchem eine gleichmässigere Abscheidungsverteilung an der Abscheidungsanordnung erzielbar ist. Dies wird bei Ausbildung der Anlage nach dem Kennzeichen von Anspruch 1 erreicht, bzw. bei Durchführung des erwähnten Verfahrens nach dem Kennzeichen von Anspruch 9.

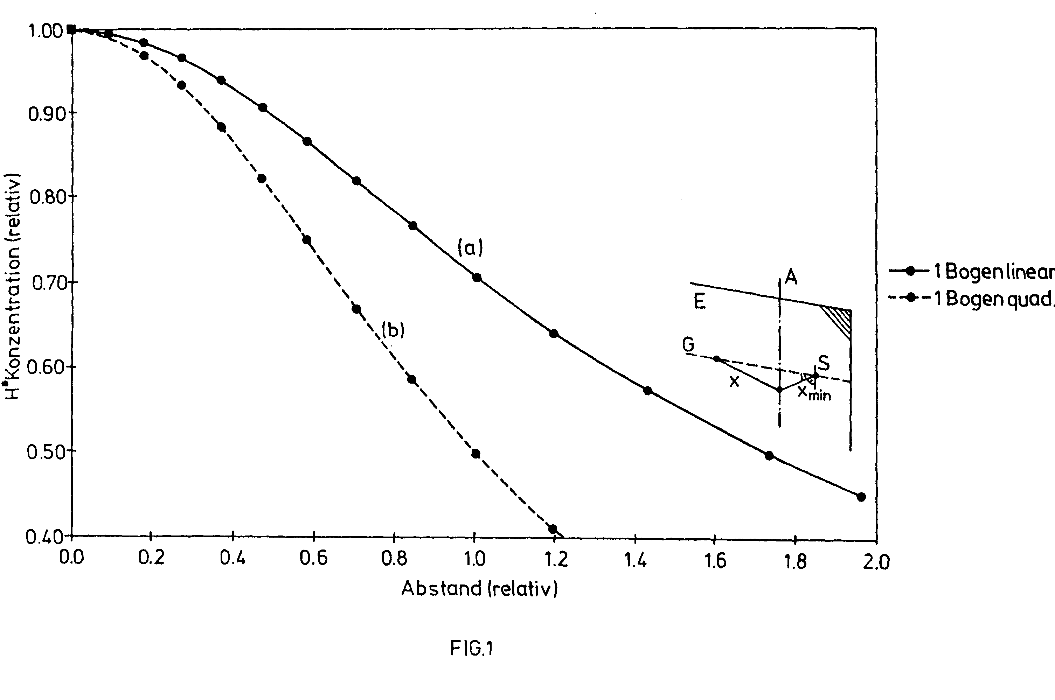

Bei Vorgehen gemäss der EP 724 026 wurde erkannt, dass, insbesondere aufgrund seiner Zylindersymmetrie bezüglich der Achse des einen Plasmastrahls, sich komplexe Abhängigkeiten der Konzentration reaktiver Spezies vom radialen Abstand von der Strahlachse ergeben. Wird insbesondere die für die Erzeugung von Diamantmaterial entscheidend wichtige lokale Konzentration von atomarem Wasserstoff bei diesem vorbekannten Vorgehen und in Funktion des radialen Abstandes von der Plasmastrahlachse betrachtet, so zeigt eine Modellrechnung gemäss Fig. 1 die Konzentrations-Abnahme mit zunehmender Radialdistanz, bei Annahme lineare Abstandsabhängigkeit gemäss (a) und bei Annahme quadratischer Abstandsabhängigkeit gemäss (b).

In Fig. 1 ist wie erläutert die Konzentrations-Funktion dargestellt entlang einer Ebene E, welche mit einem Abstand xₘᵢₙ parallel zur Plasmastrahlachse A angeordnet ist und betrachtet entlang einer Geraden g in der Ebene E senkrecht zur Strahlachse A. Das Abstandsmass ist mit xₘᵢₙ normiert, das Konzentrationsmass bezüglich der Maximalkonzentration auf der Ebene E am Ort S des Abstandes xₘᵢₙ.

Aus dieser Darstellung ist ersichtlich, warum dieses vorbekannte Vorgehen bezüglich Abscheidungsraten-Verteilung insbesondere bei grösseren zu beschichtenden Werkstückflächen Probleme aufwirft, sofern die eine betrachtete Werkstückoberfläche oder mehrere Werkstücke, jeweils mit entsprechenden Oberflächen, nicht rotationssymmetrisch um die Strahlachse A angeordnet werden.

Diese Probleme werden durch das vorgeschlagene erfindungsgemässe Verfahren wesentlich gemindert.

### Definitionen

Wir verwenden in der vorliegenden Beschreibung den Ausdruck "Werkstück-Trägerfläche" dann, wenn erfindungsgemäss eine Werkstückbehandlung, insbesondere Beschichtung, angesprochen ist. Wir sprechen von einer "Auffangfläche", wenn eine Pulver- bzw. Clustererzeugung angesprochen ist. Wir sprechen generell von "Abscheidungsfläche" bzw. "Abscheidungsanordnung", wenn gemeinsam sowohl eine "Werkstück-Trägerfläche" wie auch eine "Auffangfläche" angesprochen ist.

In einer besonders bevorzugten Ausführungsform der erfindungsgemässen Verfahren wird auf die Abscheidungsfläche ein metastabiles Material, dabei bevorzugt cBN, α-Al₂O₃, C₃N₄ oder, und besonders bevorzugt, Diamant abgeschieden.

In einer weiteren bevorzugten Ausführungsform des erfindungsgemässen Verfahrens wird eine Siliziumverbindung auf die Abscheidungsfläche abgelegt, dabei bevorzugt mikrokristallines Silizium µC-Si:H und dabei bevorzugt als Reaktivgas Silan eingesetzt.

In einer bevorzugten Ausführungsform werden dabei die Plasmastrahlen als Niedervolt-Bogenentladungen, bei weitem bevorzugt als sog. Hochstrom-Bogenentladungen, realisiert, dies bevorzugt mittels Kaltkathoden-Entladungen, aber insbesondere bevorzugt mittels Heisskathoden-Entladungen.

Im weiteren wird die Abscheidungsfläche so in der Vakuumatmosphäre und bezüglich der Plasmastrahlen angeordnet, dass entlang dieser Fläche vorgegebene minimale Plasmadichte-Schwankungen auftreten. Dies wird insbesondere dadurch erreicht, dass entlang der erwähnten Abscheidungsfläche Plasmadichten von höchstens 20 %, vorzugsweise von höchstens 10 %, vorzugsweise gar höchstens von 5 % der Plasmadichtemaxima der jeweiligen nächstgelegenen Plasmastrahlen auftreten, wobei weiter die Plasmastrahlen gleich betrieben werden können, d.h. dann im wesentlichen gleiche maximale Plasmadichten in ihren Achsen aufweisen. Es ist aber vorteilhaft, die entlang von Abscheidungsflächen, beispielsweise vorgegebener Formung, erzielte Plasmadichteverteilung durch gezielte Abstimmung der jeweiligen Entladungen zu optimieren, d.h. durch gezielte Abstimmung der strahlspezifischen, maximalen Plasmadichten. Hierzu wird weiter vorgeschlagen, dass die Plasmastrahlenladungen unabhängig voneinander betreibbar sind, womit die Möglichkeit eröffnet wird, fallspezifisch die erwähnte Optimierung vorzunehmen.

Dabei wurde zusätzlich erstaunlicherweise erkannt, dass mit dem vorgeschlagenen Verfahren eine Materialabscheidung mit sehr hohen Abscheidungsraten realisierbar ist und dies bei Temperaturen am Abscheidungsort von höchstens 500°C. Dementsprechend wird das erfindungsgemässe Verfahren bevorzugt so durchgeführt, dass bei Anordnen der Abscheidungsfläche derart, dass an ihr vorherrschende Plasmadichtemaxima 20 % der nächstgelegenen Strahlplasmadichtemaxima betragen, sich eine Abscheidungsrate an der Abscheidungsfläche von mindestens 400 nm/min einstellt, vorzugsweise bei der erwähnten Temperatur von höchstens 500°C.

In einer weiteren bevorzugten Ausführungsform wird die Plasmadichteverteilung mittels mindestens eines strahlachsenparallelen Magnetfeldes abgestimmt.

Um, was insbesondere bei der Werkstückoberflächenbehandlung wesentlich sein kann, die Behandlungswirkung - insbesondere die Beschichtungsdicken-Verteilung - an mehreren zu behandelnden Werkstücken noch mehr auszugleichen, wird weiter vorgeschlagen, dass man die Werkstücke um Rotationsachsen dreht und/oder linear mindestens genähert parallel zu den Strahlachsen bewegt, vorzugsweise pendelnd hin und her bewegt.

Im weiteren hat sich gezeigt, dass beim erfindungsgemässen Vorgehen eine noch weitere Effektivität erzielt werden kann, bezüglich gleichzeitig behandelbarer Werkstücke bzw. abgeschiedener Pulvermenge, dadurch, dass man beidseits neben den Strahlenachsen je eine Abscheidungsfläche anordnet, bzw. mehr als zwei der Plasmastrahlen erzeugt und eine Abscheidungsfläche zwischen einem Teil dieser Strahlen sich erstreckend anordnet.

Während im zweiterwähnten Fall an der Abscheidungsfläche, die zwischen den Plasmastrahlen liegt, beidseitig Material abgeschieden wird, sei dies zur Pulvergewinnung oder Werkstückbeschichtung, wird im ersterwähnten Fall an der Abscheidungsfläche nur einseitig Material abgeschieden, sei dies wiederum zur Pulvergewinnung oder für die Behandlung, wie insbesondere Beschichtung, von Werkstücken. Bezüglich Werkstücke können mithin zwei- oder mehrseitig zu beschichtende Werkstücke, wie Fräser oder Bohrer, entlang der ersten Abscheidungsfläche, hingegen Werkstücke, die nur eine einseitige Behandlung, insbesondere Beschichtung, erfordern, wie Wendeschneidplatten, entlang der zweiten Abscheidungsfläche angeordnet werden. Dadurch erhöht sich die Effizienz des Verfahrens bzw. einer hierzu vorgesehenen Anlage ganz wesentlich.

Bevorzugte Ausführungsformen der Anlage sind in den Ansprüchen 2 bis 7 spezifiziert, eine Verwendung dieser Anlagen im Anspruch 8.

Die Erfindung wird anschliessend beispielsweise anhand von weiteren Figuren und Beispielen erläutert. Es zeigen:
- Fig. 2: schematisch, in Seitenansicht, eine erfindungsgemässe Anlage zur Ausführung der erfindungsgemässen Verfahren,
- Fig. 3 bis 6: wiederum schematisch, in Aufsicht, erfindungsgemässe Anordnungen von Plasmastrahlen und Abscheidungsflächen an erfindungsgemässen Anlagen zur Ausführung der erfindungsgemässen Verfahren,
- Fig. 7: in Funktion eines Längenmasses, entlang einer durch die Strahlachse zweier Plasmastrahlen verlaufenden, diesbezüglich senkrechten Geraden und mit dem Heizstrom I von Heisskathoden-Niederspannungsentladung parametrisiert, die Plasmadichteverteilung sowie (d) die an einer ebenen Abscheidungsfläche parallel zu den Strahlachsen resultierende Plasmadichteverteilung und
- Fig. 8: in einer Darstellung analog zu Fig. 1, die modellierte, erfindungsgemässe Plasmadichteverteilung entlang einer ebenen Abscheidungsfläche, parallel zu und beabstandet von zwei vorgesehenen Plasmastrahlenachsen.

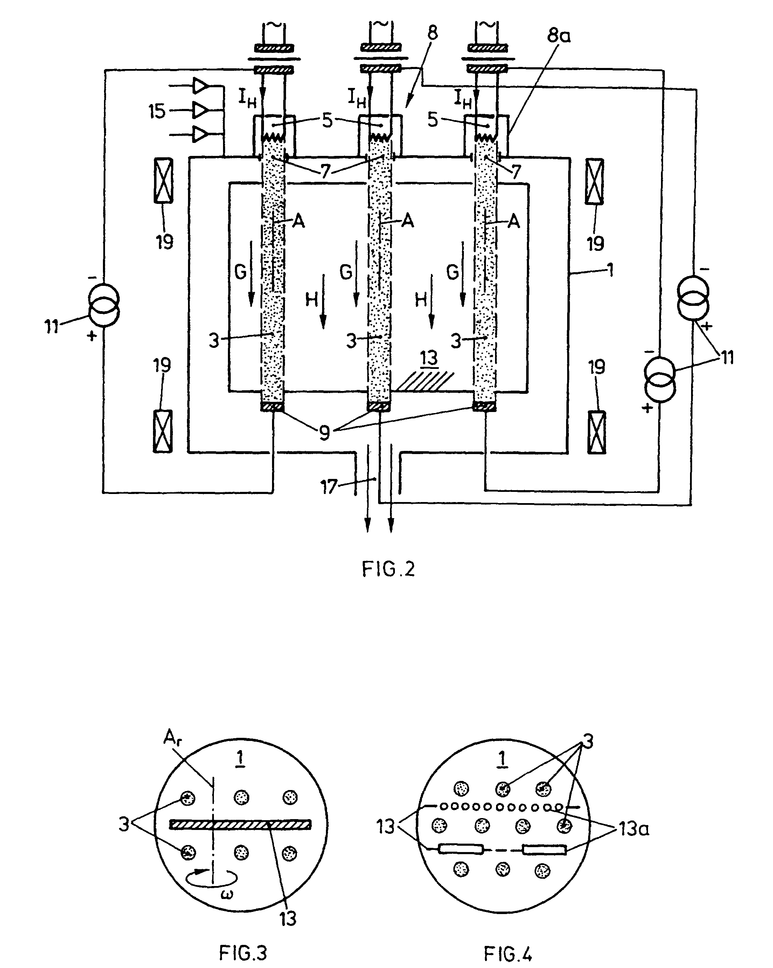

In Fig. 2 ist schematisch, im Längsschnitt, eine erfindungsgemässe Anlage dargestellt, zur Ausführung der erfindungsgemässen Verfahren. In einer Vakuumkammer 1 werden mindestens zwei, wie in den Figuren 3 bis 6 bevorzugt mindestens sechs, Plasmastrahlen 3 erzeugt. Bevorzugt werden sie, wie dies auch in Fig. 2 dargestellt ist, durch Hochstrom-Niederspannungsentladung an entsprechenden Entladungsstrecken gebildet, bevorzugt jeweils mit einer Heisskathode 5, direkt oder indirekt beheizt, wie dargestellt bevorzugt über einen Heizstromkreis mit dem Heizstrom I_{H} direkt beheizt. Die Heisskathoden 5 sind in einer Kathodenkammer-Anordnung 8, beispielsweise wie in Fig. 2 dargestellt, mit einzelnen Kathodenkammern 8a, betrieben, in welche (nicht dargestellt) ein Arbeitsgas, wie beispielsweise Argon, eingelassen wird, und welche über Blenden 7 mit dem Innern der Kammer 1 kommunizieren.

Prinzipiell können aber zur Erzeugung der Plasmastrahlen auch andere Kathodentypen verwendet werden, so beispielsweise Hohlkathoden, wenn hochreine Beschichtungen erzeugt werden sollen und verhindert werden soll, dass Verunreinigen durch sublimierte Heisskathoden-Atome entstehen.

In Fig. 2 bezeichnen weiter 9 die Entladungsstrecken-Anoden und 11 die Entladungs-Generatoren.

Zwischen den Plasmastrahlen 3, bei der Anordnung gemäss Fig. 2 bevorzugt mindestens deren sechs, wovon drei ersichtlich, sind Abscheidungsanordnungen entlang einer oder mehrerer Fläche(n) 13 vorgesehen, die in vorgegebenen Abständen von den Strahlachsen A, zwischen den Plasmastrahlen 3 durchlaufen, entsprechend erwünschten Plasmadichte-Verteilungen an diesen Flächen 13 und damit an der Abscheidungsanordnung. Die Abscheidungsflächen 13 werden bei erfindungsgemässer Werkstückbehandlung durch Werkstückträger-Flächen definiert, zur Aufnahme eines oder mehrerer Werkstücke(s), oder sie werden durch Auffangflächen gebildet, wird erfindungsgemäss eine Pulver- bzw. Clustererzeugung an diesen Flächen angestrebt.

Das Reaktivgas wird durch eine Gaseinlassanordnung 15 in die Kammer 1 eingelassen, verbrauchtes Reaktivgas an der Pumpöffnung 17 abgesaugt. Bevorzugt - und wie mit G dargestellt - wird eine zu den Achsen A der Plasmastrahlen parallele Gasströmung durch die Kammer 1 angestrebt.

Mittels Helmholzspulen 19 wird in der Kammer 1 im weiteren ein im wesentlichen zu den Strahlachsen A paralleles Magnetfeld H erzeugt, mittels welchem, zusätzlich, die lokale Plasmadichteverteilung abgestimmt werden kann.

In den Figuren 3 bis 6 sind, in Aufsicht und schematisch, die Anordnungen von Plasmastrahlen 3 dargestellt, mit erfindungsgemäss dazwischen geführten, durch Werkstückträger 13a oder Auffangflächen definierten Abscheidungsflächen 13.

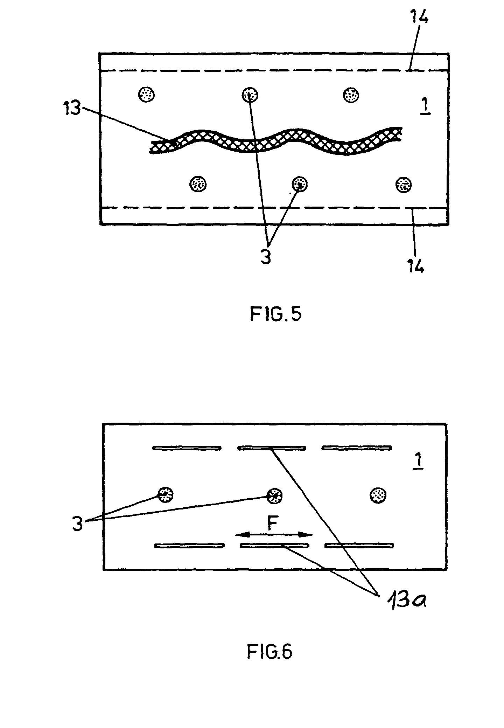

In Fig. 5 ist, wiederum in Aufsicht, eine weitere Anordnung von sechs Plasmastrahlen 3 mit Abscheidungsfläche 13 dargestellt, welche so geführt ist, dass daran beidseits eine erwünschte Plasmadichteverteilung erwirkt wird, hier mit minimaler Inhomogenität.

In Fig. 5 ist im weiteren gestrichelt dargestellt, wie nebst der zwischen den Plasmastrahlen 3 durchgeführten Abscheidungsfläche 13, worauf beidseits eingewirkt wird, zwischen den Plasmastrahlen 3 und der Rezipienten- bzw. Kammerwand weitere Abscheidungsflächen 14 angeordnet werden können, welche der Behandlung nur einseitig ausgesetzt sind. Entsprechend werden, zur Werkstückbehandlung, an der einen Abscheidungsfläche 13 zwei- oder allseitig zu behandelnde, insbesondere zu beschichtende, Werkstücke vorgesehen, an den Abscheidungsflächen 13a nur einseitig zu behandelnde, insbesondere zu beschichtende.

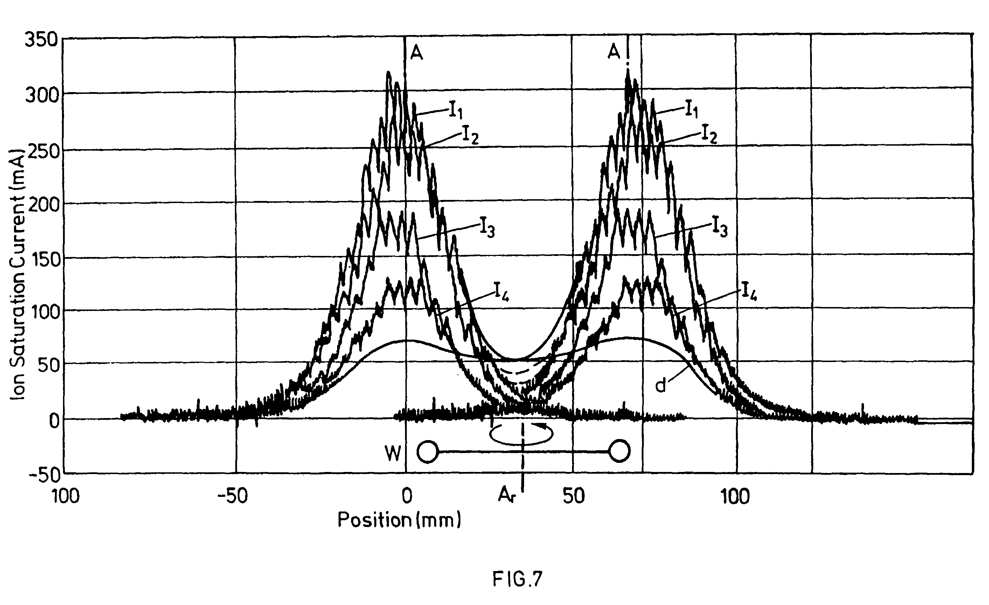

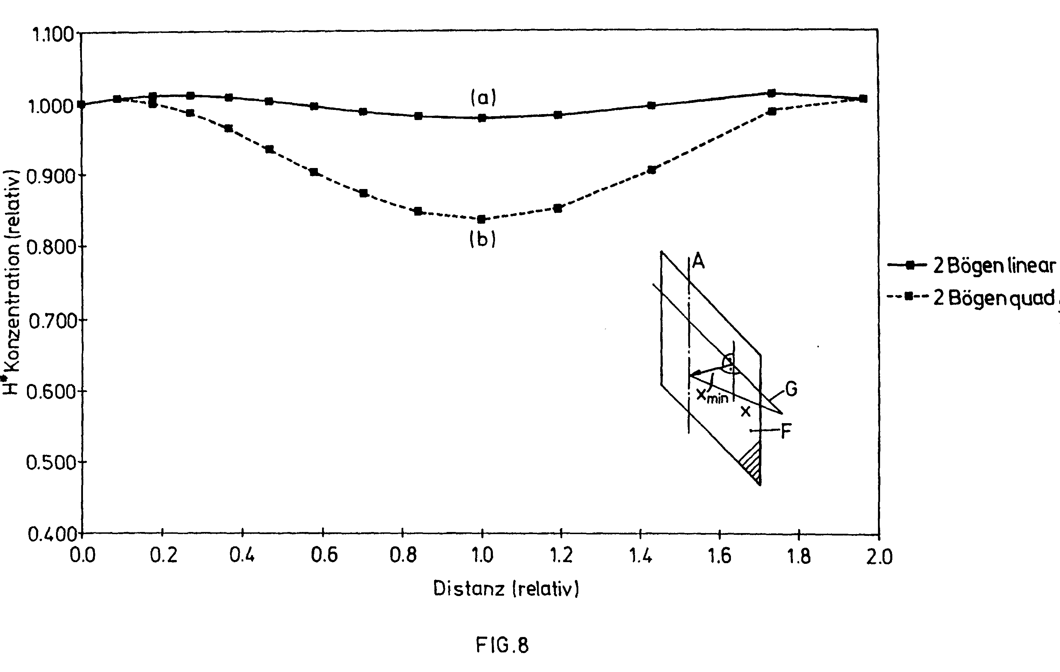

In Fig. 7 ist in Funktion des Heizstromes I die von zwei beabstandeten Plasmastrahlen resultierende Plasmadichteverteilung dargestellt. Wird nun eine ebene Abscheidungsfläche parallel zur Figurenebene von Fig. 7 in einen Bereich gelegt, derart, dass an dieser Fläche Plasmadichtemaxima von 20 % der in Strahlachse A vorherrschenden maximalen Plasmadichten auftreten, so ergibt sich die qualitativ bei d eingetragene Plasmadichteverteilung entlang dieser Fläche. In Darstellung analog zu Fig. 1 ist eine solche Plasmadichteverteilung in Fig. 8 modelliert dargestellt, wiederum bei (a) bei angenommener linearer Abhängigkeit der Plasmadichte vom Bogenachsenabstand x, bei (b) bei quadratisch angenommener.

Je geringer die an den vorgesehenen Abscheidungsflächen ausgenützte Plasmadichte, bezogen auf die maximale Plasmadichte in den Strahlachsen A, ist, desto homogener, d.h. gleichverteilter, wird die Plasmadichteverteilung. Dass aber gleichzeitig bei nur ca. 20%iger Plasmadichte-Ausnützung trotzdem sehr hohe Abscheidungsraten von mindestens 400 nm/min bei Temperaturen von höchstens 500°C erzielbar sind, erstaunt.

Wie in Fig. 3 und in Fig. 6 mit ω dargestellt, kann eine weitere Homogenisierung der realisierten Abscheidungs-Verteilung insbesondere bei der Beschichtung dadurch erzielt werden, dass die Werkstücke um eine Achse Aᵣ, bevorzugt im wesentlichen senkrecht zu den Strahlachsen A, rotiert werden und/oder, wie in Fig. 6 dargestellt, linear entlang den Strahlachsen bewegt werden, in Fig. 6 mit dem Doppelpfeil F dargestellt.

Mit den vorgestellten erfindungsgemässen Anlagen bzw. den erfindungsgemässen Verfahren wird, wie einleitend erwähnt, im Rahmen einer werkstückbehandlung ermöglicht, einerseits schwierig herzustellende Schichten abzuscheiden, dabei insbesondere Diamantschichten grossflächig mit weitgehend konstanter Schichtdickenverteilung bzw. mit sehr hohen Abscheidungsraten und tiefen Temperaturen reaktiv Schichten abzuscheiden, dabei insbesondere auch Schichten aus Siliziumverbindungen, insbesondere aus mikrokristallinem µC-Si:H, dabei bevorzugt unter Verwendung von Silan als Reaktivgas. Anderseits ist es aber auch möglich, durch entsprechende Einstellung der Entladungsgrössen an den erwähnten Abscheidungsflächen die erwähnten Materialien als Pulver bzw. Cluster abzulegen.

## Patentansprüche

1. Vakuumbehandlungsanlage mit einer Vakuumbehandlungskammer (1), darin einer Plasmaentladungsanordnung sowie einer Gaszuführanordnung, bei der die Plasmaentladungsanordnung mindestens zwei Plasmaentladungsstrecken (5, 9) hat mit im wesentlichen parallelen, nebeneinander liegenden Entladungsachsen (A) und eine Abscheidungsanordnung entlang einer Fläche (13) positioniert ist, die sich mit vorgegebenen Abständen seitlich neben den Strahlachsen (A) und entlang eines wesentlichen Abschnittes der Entladungs-Längsausdehnung erstreckt, weiter mit einer Gasabsauganordnung, **dadurch gekennzeichnet, dass** die Plasmaentladungsstrecken Plasmastrahlentladungsstrecken sind, die Gaszuführanordnung (15) und die Absauganordnung (17) an der Vakuumkammer (1) so angeordnet sind, dass eine im wesentlichen zu den Entladungsachsen (A) parallele Gasströmung (G) durch die Kammer (1) erzeugt wird.

2. Anlage nach Anspruch 1, **dadurch gekennzeichnet, dass** mindestens eine Abscheidungsanordnung durch eine Werkstückträgeranordnung für ein oder mehrere Werkstück(e) (13a) gebildet ist.

3. Anlage nach Anspruch 1, **dadurch gekennzeichnet, dass** mindestens eine Abscheidungsanordnung durch eine im wesentlichen lückenlose, flächige Anordnung als Pulverfängerfläche ausgebildet ist.

4. Anlage nach einem der Ansprüche 1 bis 3, **dadurch gekennzeichnet, dass** die Plasmastrahl-Entladungsstrecken (5, 9) als bevorzugt unabhängig voneinander ansteuerbare Niederspannungs-Hochstrom-Bogenentladungsstrecken ausgebildet sind, bevorzugt mit Kaltkathoden, aber insbesondere bevorzugt mit Heisskathoden (5).

5. Anlage nach einem der Ansprüche 1 bis 4, **dadurch gekennzeichnet, dass** die Gaszufuhr (15) mit einer Gastankanordnung verbunden ist, worin ein kohlenstoff-, bor-, stickstoff-, wasserstoff- und/oder, dabei bevorzugt, siliziumhaltiges Gas enthalten ist.

6. Anlage nach einem der Ansprüche 1 bis 5, **dadurch gekennzeichnet, dass** mehr als zwei der Plasmastrahlentladungsstrecken vorhanden sind und die Abscheidungsanordnung sich zwischen einem Teil der Entladungsstrecken hindurch erstreckt.

7. Anlage nach einem der Ansprüche 1 bis 6, **dadurch gekennzeichnet, dass** neben den Entladungsachsen seitlich je eine Abscheidungsanordnung vorhanden ist.

8. Verwendung der Anlage nach einem der Ansprüche 1 bis 7 für die Abscheidung von metastabilen Materialien, insbesondere von cBN, α-Al₂O₃, C₃N₄ oder, und besonders bevorzugt, von Diamantmaterial, bevorzugt aber auch von mikrokristallinen Siliziumverbindungen, insbesondere von µC-Si:H.

9. Verfahren zur Herstellung durch einen Vakuumprozess abgelegten Materials, bei dem in einer Vakuumatmosphäre mindestens zwei Plasmaentladungen mit im wesentlichen parallelen, nebeneinander liegenden Entladungsachsen erzeugt werden, eine Abscheidungsfläche für das Material in der Vakuumatmosphäre seitlich neben den Entladungsachsen angeordnet wird und Reaktivgas in die Vakuumatmosphäre eingelassen sowie Gas aus der Vakuumatmosphäre abgepumpt wird, **dadurch gekennzeichnet, dass** die Plasmaentladungen als Plasmastrahlentladungen erzeugt werden und in der Vakuumatmosphäre eine im wesentlichen zu den Strahlachsen parallel gerichtete Gasströmung erzeugt wird.

10. Verfahren nach Anspruch 9, **dadurch gekennzeichnet, dass** als Abscheidungsfläche die Oberfläche ein oder mehrerer Werkstücke eingesetzt wird und das Material als Schicht abgelegt wird.

11. Verfahren nach Anspruch 9, **dadurch gekennzeichnet, dass** als Material Pulver auf die Abscheidungsfläche abgeschieden wird.

12. Verfahren nach einem der Ansprüche 9 bis 11, **dadurch gekennzeichnet, dass** eine Siliziumverbindung auf die Abscheidungsfläche abgelegt wird, bevorzugt mikrokristallines Silizium µC-Si:H und dabei bevorzugt als Reaktivgas Silan eingesetzt wird.

13. Verfahren nach einem der Ansprüche 9 bis 12, **dadurch gekennzeichnet, dass** auf die Abscheidungsfläche metastabiles Material, bevorzugt cBN, α-Al₂O₃, C₃N₄ oder und bevorzugt Diamant abgeschieden wird.

14. Verfahren nach einem der Ansprüche 9 bis 13, **dadurch gekennzeichnet, dass** die Plasmastrahlen als Niedervolt-Bogenentladungen, realisiert werden, weiter bevorzugt mittels Kaltkathoden-Entladungen, dabei insbesondere bevorzugt mittels Heisskathoden-Entladungen.

15. Verfahren nach einem der Ansprüche 9 bis 14, **dadurch gekennzeichnet, dass** die Abscheidungsfläche so in der Vakuumatmosphäre und bezüglich der Plasmastrahlen angeordnet wird, dass entlang der Fläche vorgegebene minimale Plasmadichte-Schwankungen auftreten.

16. Verfahren nach einem der Ansprüche 9 bis 15, **dadurch gekennzeichnet, dass** beidseits neben den Strahlachsen je eine Abscheidungsfläche angeordnet wird.

17. Verfahren nach einem der Ansprüche 9 bis 15, **dadurch gekennzeichnet, dass** mehr als zwei der Plasmastrahlen erzeugt werden und eine Abscheidungsfläche zwischen einem Teil dieser Strahlen sich ersteckend angeordnet wird.

18. Verfahren nach einem der Ansprüche 9 bis 17, **dadurch gekennzeichnet, dass** entlang der Abscheidungsfläche Plasmadichten von höchstens 20 %, vorzugsweise von höchstens 10 %, vorzugsweise gar höchstens von 5 %, auftreten, und zwar in jeweils Plasmastrahl-nächstgelegenen Bereichen und bezüglich der Plasmadichtemaxima der nächstgelegenen Plasmastrahlen.

19. Verfahren nach einem der Ansprüche 9 bis 18, **dadurch gekennzeichnet, dass** die Plasmastrahlentladungen unabhängig voneinander betreibbar sind.

20. Verfahren nach einem der Ansprüche 9 bis 19, **dadurch gekennzeichnet, dass** bei einem Anordnen der Abscheidungsfläche derart, dass an ihr vorherrschende Plasmadichtemaxima 20 % der jeweils nächstgelegenen Strahlplasmadichtemaxima betragen, eine Abscheidungsrate an der Abscheidungsfläche von mindestens 400 nm/min eingestellt wird, vorzugsweise bei einer Abscheidungsflächen-Temperatur von höchstens 500°C.

21. Verfahren nach einem der Ansprüche 9 bis 20, **dadurch gekennzeichnet, dass** man die Plasmadichteverteilung mittels mindestens eines Strahlachsen-parallelen Magnetfeldes abstimmt.

22. Verfahren nach einem der Ansprüche 10 und 12 - 21, sofern von Anspruch 10 abhängig, **dadurch gekennzeichnet, dass** man mehrere Werkstücke entlang der Fläche anordnet. und sie bevorzugt um Rotationsachsen dreht und/oder linear mindestens genähert parallel zu den Strahlachsen bewegt, vorzugsweise pendelnd hin und her bewegt.

## Claims

1. Vacuum treatment plant with a vacuum treatment chamber (1), therein a plasma discharge arrangement and a gas supply arrangement, where the plasma discharge arrangement has at least two plasma discharge paths (5, 9) with essentially parallel discharge axes (A) disposed side by side and a deposition device positioned along a surface (13) extending laterally at preset distances next to the radiation axes (A) and along an essential section of the discharge longitudinal extent, further with a gas exhaust arrangement, **characterised in that** the plasma discharge paths are plasma beam discharge paths, the gas supply arrangement (15) and the exhaust arrangement (17) being arranged on the vacuum chamber (1) so that a gas flow (G) through the chamber (1) is generated which is essentially parallel to the discharge axes (A).

2. Plant according to claim 1, **characterised in that** at least one deposition arrangement is formed by a workpiece carrier arrangement for one or more workpieces (13a).

3. Plant according to claim 1, **characterised in that** at least one deposition arrangement is formed by an essentially uninterrupted two-dimensional arrangement as a powder catching surface.

4. Plant according to any of claims 1 to 3, **characterised in that** the plasma beam discharge paths (5, 9) are formed as preferably independently controllable, low voltage, high current arc discharge paths, preferably with cold cathodes but in particular preferably with hot cathodes (5).

5. Plant according to any of claims 1 to 4, **characterised in that** the gas supply (15) is connected with a gas tank arrangement that contains a gas comprising carbon, boron, nitrogen, hydrogen and/or thereby, preferably, silicon.

6. Plant according to any of claims 1 to 5, **characterised in that** there are more than two plasma beam discharge paths and the deposition arrangement extends between a part of the discharge paths.

7. Plant according to any of claims 1 to 6, **characterised in that** a deposition arrangement is arranged on each side next to the discharge axes.

8. Use of the plant according to any of claims 1 to 7 for the deposition of metastable materials, in particular of cBN, α-Al₂O₃, C₃N₄ or, particularly preferably, of diamond material, also preferably of microcrystalline silicon compounds, in particular of µC-Si:H.

9. Process for the production of material deposited by a vacuum process, where in a vacuum atmosphere at least two plasma discharges are generated with essentially parallel, discharge axes disposed side by side, a deposition surface for the material is arranged laterally next to the discharge axes in the vacuum chamber and reactive gas is introduced into the vacuum atmosphere and gas is evacuated from the vacuum atmosphere, **characterised in that** the plasma discharges are generated as plasma beam discharges and in the vacuum atmosphere a gas flow is generated which is oriented essentially parallel to the beam axes.

10. Process according to claim 9, **characterised in that** as a deposition surface, the surface of one or more workpieces is used and the material is deposited as a layer.

11. Process according to claim 9, **characterised in that** as a material, powder is deposited on the deposition surface.

12. Process according to any of claims 9 to 11, **characterised in that** a silicon compound is deposited on the deposition surface, preferably microcrystalline silicon µC-Si:H, and thereby preferably silane is used as a reactive gas.

13. Process according to any of claims 9 to 12, **characterised in that** on the deposition surface is deposited metastable material, preferably cBN, α-Al₂O₃, C₃N₄ or preferably diamond.

14. Process according to any of claims 9 to 13, **characterised in that** the plasma beams are implemented as low voltage arc discharges, further preferably by means of cold cathode discharges, particularly preferably by means of hot cathode discharges.

15. Process according to any of claims 9 to 14, **characterised in that** the deposition surface is arranged in the vacuum atmosphere and in relation to the plasma beams so that along the surface, prespecified minimal plasma density fluctuations occur.

16. Process according to any of claims 9 to 15, **characterised in that** a deposition surface is arranged on both sides next to the beam axes.

17. Process according to any of claims 9 to 15, **characterised in that** more than two of the plasma beams are generated and a deposition surface is arranged extending between a part of these beams.

18. Process according to any of claims 9 to 17, **characterised in that** along the deposition surface plasma densities occur of maximum 20%, preferably of maximum 10%, preferably even of maximum 5%, in areas next to the plasma beams, and relative to plasma density maxima of plasma beams located next.

19. Process according to any of claims 9 to 18, **characterised in that** the plasma beam discharges can be operated independently of each other.

20. Process according to any of claims 9 to 19, **characterised in that** when the deposition surface is arranged such that the plasma density maximum predominating there amount to 20% of the nearest beam plasma density maxima, a deposition rate is set of least 400 nm/min at the deposition surface, preferably with a deposition surface temperature of maximum 500°C.

21. Process according to any of claims 9 to 20, **characterised in that** the plasma density distribution is set by means of at least one magnetic field parallel to the beam axes.

22. Process according to any of claims 10 and 12 to 21 where dependent on claim 10, **characterised in that** several workpieces are arranged along the surface and are preferably rotated about rotation axes and/or are moved linearly at least approximately parallel to the beam axes, preferably oscillatingly to and fro.

## Revendications

1. Installation de traitement sous vide comportant une chambre de traitement sous vide (1) et, dans celle-ci, un dispositif de décharge de plasma et un dispositif d'amenée de gaz, dans laquelle le dispositif de décharge de plasma a au moins deux espaces de décharge de plasma (5, 9) avec des axes de décharge (A) juxtaposés et sensiblement parallèles, et un dispositif de dépôt est positionné le long d'une surface (13) qui s'étend à des distances prédéfinies, latéralement, près des axes de décharge et le long d'une section essentielle de l'étendue longitudinale des décharges, et comportant aussi un dispositif d'aspiration de gaz,
**caractérisée en ce que** les espaces de décharge de plasma sont constitués par des espaces de décharge de jet de plasma et le dispositif d'amenée de gaz (15) et le dispositif d'aspiration (17) sont disposés sur la chambre à vide (1) de telle sorte qu'un écoulement de gaz (G) sensiblement parallèle aux axes de décharge (A) soit produit à travers la chambre (1).

2. Installation selon la revendication 1, **caractérisée en ce qu'**au moins un dispositif de dépôt est formé par un dispositif porte-pièce pour une ou plusieurs pièces (13a).

3. Installation selon la revendication 1, **caractérisée en ce qu'**au moins un dispositif de dépôt est conçu comme une surface collectrice de poudre grâce à une disposition à deux dimensions pratiquement continue.

4. Installation selon l'une des revendications 1 à 3, **caractérisée en ce que** les espaces de décharge de jet de plasma (5, 9) sont conçus de préférence comme des espaces de décharge en arc basse tension à haute intensité de préférence aptes à être commandées indépendamment les uns des autres, comportant de préférence des cathodes froides, mais en particulier des cathodes chaudes (5), de préférence.

5. Installation selon l'une des revendications 1 à 4, **caractérisée en ce que** l'amenée de gaz (15) est reliée à un dispositif formant réservoir de gaz qui contient un gaz contenant du carbone, du bore, de l'azote, de l'hydrogène et/ou, de préférence, du silicium.

6. Installation selon l'une des revendications 1 à 5, **caractérisée en ce qu'**il est prévu plus de deux espaces de décharge de jet de plasma et le dispositif de dépôt s'étend entre une partie des espaces de décharge.

7. Installation selon l'une des revendications 1 à 6, **caractérisée en ce qu'**il est prévu un dispositif de dépôt respectivement, latéralement, à côte des axes de décharge.

8. Utilisation de l'installation selon l'une des revendications 1 à 7 pour le dépôt de matières métastables, en particulier de cBN, α-Al₂O₃, C₃N₄ ou plus particulièrement de matière diamantée, mais de préférence aussi de composés de silicium microcristallin, en particulier de µC-Si:H.

9. Procédé pour fabriquer une matière déposée grâce à un procès sous vide, selon lequel on génère dans une atmosphère sous vide au moins deux décharges de plasma avec des axes de décharge juxtaposés et sensiblement parallèles, on dispose une surface de dépôt pour la matière dans l'atmosphère sous vide, latéralement près des axes de décharge, et un gaz réactif est introduit dans cette atmosphère et du gaz est évacué de celle-ci par pompage,
**caractérisé en ce que** les décharges de plasma sont produites sous la forme de décharges de jet de plasma, et un écoulement de gaz sensiblement parallèle aux axes des jets est produit dans l'atmosphère.

10. Procédé selon la revendication 9, **caractérisé en ce qu'**on utilise comme surface de dépôt la surface d'une ou plusieurs pièces, et la matière est déposée sous forme de couche.

11. Procédé selon la revendication 9, **caractérisé en ce qu'**on dépose comme matière de la poudre sur la surface de dépôt.

12. Procédé selon l'une des revendications 9 à 11, **caractérisé en ce qu'**on dépose sur la surface de dépôt un composé du silicium, de préférence du silicium microcristallin µC-Si:H, et on utilise de préférence comme gaz réactif du silane.

13. Procédé selon l'une des revendications 9 à 12, **caractérisé en ce qu'**on dépose sur la surface de dépôt une matière métastable, de préférence cBN, α-Al₂O₃, C₃N₄ ou et de préférence du diamant.

14. Procédé selon l'une des revendications 9 à 13, **caractérisé en ce que** les jets de plasma sont réalisés sous la forme de décharge en arc basse tension, de préférence à l'aide de décharges à cathodes froides, en particulier à l'aide de décharges à cathodes chaudes, de préférence.

15. Procédé selon l'une des revendications 9 à 14, **caractérisé en ce que** la surface de dépôt est disposé dans l'atmosphère sous vide et par rapport aux jets de plasma de telle sorte que des variations de densité de plasma minimales prédéfinies apparaissent le long de la surface.

16. Procédé selon l'une des revendications 9 à 15, **caractérisé en ce qu'**une surface de dépôt est disposée de chaque côté des axes de jets.

17. Procédé selon l'une des revendications 9 à 15, **caractérisé en ce que** plus de deux jets de plasma sont produits et une surface de dépôt est disposée entre une partie de ces jets.

18. Procédé selon l'une des revendications 9 à 17, **caractérisé en ce que** des densités de plasma de 20 % au maximum, de préférence de 10 % au maximum, et même de préférence de 5 % au maximum, apparaissent le long de la surface de dépôt, et ce dans les zones les plus proches du jet de plasma et par rapport aux maxima de densité de plasma des jets de plasma les plus proches.

19. Procédé selon l'une des revendications 9 à 18, **caractérisé en ce que** les décharges de jet de plasma sont aptes à fonctionner indépendamment les unes des autres.

20. Procédé selon l'une des revendications 9 à 19, **caractérisé en ce que** lorsque la surface de dépôt est disposée de telle sorte que les maxima de densité de plasma prédominant sur elle représentent 20 % des maxima de densité de plasma de jets les plus proches, on règle une vitesse de dépôt sur la surface de dépôt d'au moins 400 nm/min, de préférence à une température de surface de dépôt de 500°C au maximum.

21. Procédé selon l'une des revendications 9 à 20, **caractérisé en ce qu'**on adapte la répartition de densité de plasma à l'aide d'au moins un champ magnétique parallèle aux axes de jets.

22. Procédé selon l'une des revendications 10 et 12-21 dans la mesure où elles dépendent de la revendication 10, **caractérisé en ce que** plusieurs pièces sont disposées le long de la surface et sont de préférence tournées autour d'axes de rotation et/ou déplacées linéairement au moins approximativement parallèlement aux axes de jets, de préférence suivant un mouvement de va-et-vient.
